# EUROPÄISCHE PATENTSCHRIFT

(11) **EP 1 461 827 B1**
(45) Veröffentlichungstag und Bekanntmachung des Hinweises auf die Patenterteilung: **19.10.2011**
(21) Anmeldenummer: 01976169.1
(22) Anmeldetag: 30.08.2001
(51) Int. Cl.: H01L 21/02

(54) **VERFAHREN ZUR VERBESSERUNG DER EFFIZIENZ VON EPITAKTISCH HERGESTELLTEN QUANTENPUNKT-HALBLEITERBAUELEMENTEN**
METHOD FOR IMPROVING THE EFFICIENCY OF EPITAXIALLY PRODUCED QUANTUM DOT SEMICONDUCTOR COMPONENTS
PROCEDE D'AMELIORATION DE L'EFFICACITE DE COMPOSANTS A SEMI-CONDUCTEUR A POINTS QUANTIQUES PRODUITS DE MANIERE EPITAXIALE

(30) Priorität: 30.08.2000 DE 10044040
(43) Veröffentlichungstag der Anmeldung: 29.09.2004
(73) Patentinhaber: Technische Universität Berlin, 10623 Berlin (DE)
(72) Erfinder: SELLIN, Roman, 72760 Reutlingen (DE); LEDENTSOV, Nikolai, N., 10717 Berlin (DE); BIMBERG, Dieter, 14089 Berlin (DE)
(74) Vertreter: Gulde, Klaus W.
(86) Internationale Anmeldenummer: PCT/EP2001/010015
(87) Internationale Veröffentlichungsnummer: WO 2002/019402

(56) Entgegenhaltungen:
- WO-A-01/17035
- WO-A-90/03659
- DE-A- 19 819 259
- US-A- 5 614 435
- US-B1- 6 242 326

## Beschreibung

Die Erfindung bezieht sich auf ein Verfahren zur Verbesserung der Effizienz von epitaktisch hergestellten Quantenpunkt-Halbleiterbauelementen gemäß dem Oberbegriff des Patentanspruches 1.

QP-Bauelemente aus Halbleitermaterialien, wie zum Beispiel Laserdioden, Verstärker, Modulatoren oder Photodetektoren, deren aktive Zone aus einer oder mehreren QP-Schichten besteht, werden seit mehreren Jahren weltweit hergestellt und untersucht. Für Halbleiterlaser-Dioden mit QP als Gewinnmedium z.B. wurden bereits in den 80er Jahren im Vergleich zu Quantenfilm (QF)-Laserdioden reduzierte Schwellstromdichten, erhöhte charakteristische Temperaturen, erhöhter Gewinn und differentieller Gewinn vorhergesagt [Y. Arakawa et al, Appl. Phys. Lett. 40, 939 (1982); M. Asada et al, IEEE J. Quant. Electr. QE-22, 1915 (1986)]. Im Unterschied zu Bauelementen wie z.B. QF-LEDs oder QF-Laserdioden (LDs), die seit längerem kommerziell erhältlich sind, befinden sich QP-Bauelemente noch im Stadium der Erforschung und Entwicklung.

Seit der ersten Anwendung von QP in einem Bauelement, nämlich als aktivem Medium in einer InGaAsP/InP-LED [Y. Miyamoto et al, Jpn. J. Appl. Phys. 26, L225 (1987)], ist die Herstellung von QP soweit beherrschbar geworden, dass Laserdioden gegenwärtig für konkrete Anwendungsgebiete wie für den Einsatz in der optoelektronischen Datenübertragung oder als Hochleistungs-Infrarotlaser [F. Heinrichsdorff et al, Appl. Phys..Lett. 76, 556 (2000); M. Grundmann et al, Jpn. J. Appl. Phys. 39, 2341 (2000); M. Grundmann, Physica E 5,167 (2000)] optimiert werden.

Es ist bei der Epitaxie von QP-Bauelementen nicht ohne weiteres möglich, jede Epischicht bei derjenigen Temperatur abzuscheiden, die für das entsprechende Material ideal ist. Bei optimaler Wachstumstemperatur jeder Schicht könnte die Bildung von Versetzungen weitgehend vermieden und die Konzentration an Punktdefekten minimal gehalten werden. Versetzungen und Punktdefekte sind Störungen der Periodizität des Kristallgitters und besitzen hohe Einschlusspotentiale für Ladungsträger. Zum Beispiel werden beim arsenreichen Wachstum von GaAs wie z.B. in der MOCVD oder in der MBE in erster Linie As_{Ga} und As_{Si}-Defekte erzeugt, die miteinander wechselwirken und die tiefe elektronische Störstelle EL2 erzeugen [G.B. Stringfellow, Organometallic Vapor-Phase Epitaxy: Theory and Practice, Academic Press, Inc. (1989); C.V. Reddy et al, Phys. Rev. B 54, 11290 (1996)]. Dort lokalisierte Elektronen und Löcher rekombinieren im allgemeinen nichtstrahlend. Solche nichtstrahlenden Rekombinationsprozesse können im Falle hoher Defektkonzentrationen die strahlenden Rekombinationsprozesse überwiegen und zu niedrigen Effizienzen oder gar zum Tod des betreffenden Bauelementes führen.

Temperaturen, die für das Wachstum von Schichten oberhalb der QP optimal sind, können jedoch andererseits Diffusions- und Segrationseffekte in den QP derart begünstigen, dass es zu einer Verschlechterung ihrer physikalischer Eigenschaften, wie z.B. zur Reduktion ihrer Einschlusspotentiale, oder gar zu ihrer strukturellen Zerstörung kommt. Z.B. werden im Stranski-Krastanow-Wachstumsmodus [US-Patent 5,614,435] die QP typischerweise bei Temperaturen abgeschieden, die weit unterhalb der idealen Wachstumstemperatur der darüberliegenden Barrierenmaterialien liegen. Bevor nach dem QP-Wachstum die Reaktortemperatur wieder hochgefahren wird, müssen die QP erst überwachsen werden, um das QP-Ensemble gegen eine thermodynamisch bedingte Umstrukturierung und die thermisch begünstigte Bildung von Versetzungen zu stabilisieren (s.u.). Vorzeitiges Aufheizen der Probe würde die QP zerstören. Ein Teil des Deckmaterials muß daher unterhalb seiner idealen Wachstumstemperatur abgeschieden werden.

Von niedrigen Wachstumstemperaturen als Ursache für die Entstehung von Defekten abgesehen, kann die Bildung von QP selbst eine Quelle von Defekten darstellen. Im erwähnten Stranski-Krastanow(SK)-Wachstumsmodus beispielsweise besitzt das QP-Halbleitermaterial eine größere Gitterkonstante als das Substrat, auf der das QP-Halbleitermaterial abgeschieden wird. Die sich aus der Gitterfehlanpassung ergebende Materialverspannung ist die treibende Kraft für die Entstehung von Quantenpunkten. Dabei weicht das Material der Verspannung aus, indem es sich zu 3D-Inseln zusammenzieht, die in Wachstumsrichtung elastisch relaxieren. Für ein gegebenes Materialsystem besitzen Dichte und Größe der 3D-Inseln stabile Gleichgewichtswerte [V.A. Shchukin et al, Phys. Rev. Lett. 75, 2968 (1995); N.N. Ledentsov et al, Sol. St. Electr. 40, 78 (1996)]. Bedingt durch kinetische Effekte oder auch durch zu hohe Verspannungsenergien kann das Material zusätzlich durch die Bildung einzelner Versetzungen oder gar von Versetzungsclustern, die vollständig relaxiert sind, Verspannungen abbauen.

Der Erfindung liegt die Aufgabe zugrunde, ein Verfahren anzubieten, mit dem eine deutliche Verbesserung der Effizienz von epitaktisch hergestellten Quantenpunkt-Halbleiterbauelementen durch Reduktion von elektrischen Verlusten und optischen Streuverlusten gelingt.

Die Lösung der Aufgabe erfolgt mit den kennzeichnenden Merkmalen des Patentanspruches 1.

Vorteilhafte Weiterbildungen sind in den Unteransprüchen angegeben.

Die Effizienz von Bauelementen wird durch das erfindungsgemäße Verfahren dadurch deutlich verbessert, dass während der Wachstumsunterbrechung Ausheilprozesse von Defekten stattfinden, die beim Wachstum der Quantenpunkte oder beim Überwachsen mit Barrierenmaterial bei niedrigen Temperaturen entstanden sind. Es können dabei Leerstellen vernichtet werden [N.N. Ledentsov et al, Sol. St. Electr. 40, 78 (1996)] und Zwischengitteratome desorbieren, sofern diese durch Diffusion die Oberfläche erreichen.

Versetzungslinien können auswachsen, sofern sie nicht zu tief in die Probe hineinreichen. Es ist daher wichtig, dass sich die QP während der Wachstumsunterbrechung möglichst nah an der Oberfläche befinden.

Gemäß der Weiterbildung des Anspruches 2 ist die Temperatur während der Wachstumsunterbrechung höher als die Wachstumstemperatur der QP. Dadurch werden die beschriebenen Ausheilprozesse thermisch angeregt. Darüber hinaus kann das Abdampfen von Versetzungsclustern bewirkt werden, die sich in der QP-Schicht gebildet haben [N.N. Ledentsov et al, Semicond. Sci. Technol. 15, 604 (2000)]. Dies ist möglich, wenn die Cluster aufgrund ihrer Größe über die Höhe der QP hinausragen und das QP-Material, aus dem auch die Versetzungscluster bestehen, bei der Temperatur und Dauer der Wachstumsunterbrechung instabil gegen Desorption ist.

Das erfindungsgemäße Verfahren bewirkt eine Steigerung der Effizienz von QP-Bauelementen durch die Reduktion von Gitterfehlern und damit eine Reduktion von elektrischen Verlusten.

Darüber hinaus führen die Weiterbildungen gemäß der Ansprüche 3 bis 10 zu einer Steigerung der Effizienz optoelektronischer Bauelemente durch die Reduktion von Streuverlusten der optischen Welle an korrugierten Heteroübergängen zwischen Materialien unterschiedlicher Brechungsindizes. Solche Korrugationen können einige Nanometer hoch sein [F. Heinrichsdorff et al, J. Cryst. Growth 195, 540 (1998), Fig. 1(a)] und in den verschiedenen Richtungen der Wachstumsebene unterschiedliche Perioden haben. Sie entstehen, wenn QP bei niedrigen Temperaturen überwachsen werden. Während der erfindungsgemäßen Wachstumsunterbrechung findet eine Umverteilung des Deckschichtmaterials statt, welches zu einer Glättung der Oberfläche führt. Je nach Fehlorientierung des Substrats bewirkt die Wachstumsunterbrechung die Wiederherstellung einer Monolagen-Terrassenstruktur.

Die Wiederherstellung der Monolagen-Oberflächenmorphologie der QP-Deckschicht erlaubt gemäß der Weiterbildung nach Anspruch 11, unmittelbar auf die Deckschicht eine weitere Lage von QP abzuscheiden. Das Abscheiden von QP-Material im SK-Wachstumsmodus auf korrugierten Oberflächen führt zu einer starken Versetzungsbildung auf Kosten der QP-Dichte. Die Ausgestaltung gemäß Anspruch 12 schließt diesen Fall aus. Dies bedeutet, dass die QP-Dichte der nachfolgenden QP-Schicht mit der Dichte der vorhergehenden Schicht vergleichbar ist, wenn beide Schichten unter sonst gleichen Wachstumsbedingungen abgeschieden wurden.

Neben den Vorteilen, die das erfindungsgemäße Verfahren für die Effizienz von QP-Bauelementen bedeutet, erfordert die Herstellung von QP-Bauelementen z.B. im SK-Modus ohne das hier beschriebene Verfahren die Auffindung eines engen Fensters von Epitaxie-Parametern, in dem der Prozess stabilisiert werden muß. Außerhalb dieses Fensters ist die Herstellung von bauelementtauglichen Quantenpunkten nicht möglich. Dieses Parameterfenster ist deutlich kleiner als bei der Epitaxie von QF-Bauelementen. Die Anforderungen an die Stabilität industrieller Epitaxieprozesse zur Herstellung von QP-Bauelementen ist daher außergewöhnlich hoch. Durch den Einsatz des beschriebenen Verfahrens können diese Anforderungen stark eingeschränkt werden, da es die beschriebene Defektreduktion ermöglicht, am Rande oder selbst außerhalb des beschriebenen Parameterfensters bauelementtaugliche QP herzustellen.

Verwendete Abkürzungen:
- AS_{Ga}: Ein Punktdefekt in GaAs: ein Arsen-Atom befindet sich im Gruppe-III-Untergitter an der Stelle eines Ga-Atoms
- As_{Si}: Ein Punktdefekt: ein Arsen-Atom befindet sich auf einem Zwischengitterplatz.
- DLTS: Deep Level Transient Spectroscopy
- GaAs: Galliumarsenid
- InGaAs: Indium-Gallium-Arsenid
- InGaAsP: Gallium-Indium-Arsenid-Phosphid
- InP: Indiumphosphid
- LD: Laserdiode ("laser diode")
- LED: "light-emitting diode"
- MBE: Molecular Beam Epitaxy
- MOCVD: Metalorganic Chemical Vapor Deposition
- OF: Oberfläche
- QF: Quantenfilm(e) (n)
- QP: Quantenpunkt (e) (n)

## Patentansprüche

1. Verfahren zur Verbesserung der Effizienz von epitaktisch hergestellten Quantenpunkt-Halbleiterbauelementen mj.t einer oder mehreren Quantenpunktschichten, die mit einer Schicht Halbleitermaterial überwachsen wurde, die mindestens so dick ist, dass alle Quantenpunkte vollständig bedeckt sind,
**dadurch gekennzeichnet, dass**
das Wachstum des Halbleiterbauelements stets unterbrochen wird, nachdem eine Schicht kohärenter Quantenpunkte mit einer Schicht Halbleitermaterial überwachsen wurde, so dass Ausheilprozesse von Defekten stattfinden.

2. Verfahren nach Anspruch 1,
**dadurch gekennzeichnet, dass**
die Substrattemperatur während der Wachstumsunterbrechung höher ist als die Temperatur, bei der das Quantenpunktmaterial abgeschieden wurde.

3. Verfahren nach Anspruch 1 oder 2,
**dadurch gekennzeichnet, dass**
es sich bei dem Halbleiterbauelement um ein optoelektronisches Bauelement handelt.

4. Verfahren nach mindestens einem der Ansprüche 1 bis 3,
**dadurch gekennzeichnet, dass**
das Halbleiterbauelement einen wellenleiter enthält.

5. Verfahren nach mindestens einem der Ansprüche 1 bis 4,
**dadurch gekennzeichnet, dass**
es sich bei dem Halbleiterbauelement um einen Laser handelt.

6. Verfahren nach mindestens einem der Ansprüche 1 bis 4,
**dadurch gekennzeichnet, dass**
es sich bei dem Halbleiterbauelement um einen Verstärker handelt.

7. Verfahren nach mindestens einem der Ansprüche 1 bis 4,
**dadurch gekennzeichnet, dass**
es sich bei dem Halbleiterbauelement um einen Modulator handelt.

8. Verfahren nach mindestens einem der Ansprüche 1 bis 4,
**dadurch gekennzeichnet, dass**
es sich bei dem Halbleiterbauelement um einen Photodetektor handelt.

9. Verfahren nach Anspruch 1 oder 2,
**dadurch gekennzeichnet, dass**
die Wachstumsfront während der Wachstumsunterbrechung geglättet wird.

10. Verfahren nach mindestens einem der Ansprüche 1 bis 4 und 9,
**dadurch gekennzeichnet, dass**
die Wellenleiterverluste verringert werden.

11. Verfahren nach mindestens einem der Ansprüche 1 bis 10,
**dadurch gekennzeichnet, dass**
bei einem Mehrfachstapel von Quantenpunktschlichten die Deposition einer nachfolgenden QP-Schicht unmittelbar nach der in Anspruch 1 beschriebenen Wachstumsunterbrechung erfolgt.

## Claims

1. A method for improving the efficiency of epitaxial produced quantum dot semiconductor components with one or more quantum dot layers, which has been overgrown with a layer of semiconductor material, which is at least thick enough that all quantum dots are fully covered,
**characterized in that**
the growth of the semiconductor component is always interrupted after a layer of coherent quantum dots has been overgrown with a layer of semiconductor material, so that recovery processes of defects occur.

2. A method according to claim 1,
**characterized in that**
the substrate temperature during the growth interruption is greater than the temperature at which the quantum dot material was separated.

3. A method according to either of claims 1 or 2,
**characterized in that**
the semiconductor component is an optoelectronic component.

4. A method according to at least one of claims 1 to 3,
**characterized in that**
the semiconductor component contains a waveguide.

5. A method according to at least one of claims 1 to 4,
**characterized in that**
the semiconductor component is a laser.

6. A method according to at least one of claims 1 to 4,
**characterized in that**
the semiconductor component is a booster.

7. A method according to at least one of claims 1 to 4,
**characterized in that**
the semiconductor component is a modulator.

8. A method according to at least one of claims 1 to 4,
**characterized in that**
the semiconductor component is a photodetector.

9. A method according to either of claims 1 or 2,
**characterized in that**
the growth front is smoothed during the growth interruption.

10. A method according to at least one of claims 1 to 4 and 9,
**characterized in that**
the waveguide losses are reduced.

11. A method according to at least one of claims 1 to 10,
**characterized in that**
with a multiple staple of quantum dot layers, the deposition of a subsequent quantum dot layer occurs directly following the growth interruption described in claim 1.

## Revendications

1. Procédé d'amélioration de l'efficacité de composants à semi-conducteur à points quantiques produits de manière épitaxiale avec une ou plusieurs couches de points quantiques sur laquelle a poussé une couche de matériau semi-conducteur qui est au moins suffisamment épaisse pour que tous les points quantiques soient couverts complètement,
**caractérisé en ce que**
la croissance du composant à semi-conducteur est constamment interrompue après qu'une couche de matériau semi-conducteur a poussé sur une couche de points quantiques cohérents, de sorte que des processus de guérison de défauts interviennent.

2. Procédé selon la revendication 1,
**caractérisé en ce que**
la température du substrat pendant l'interruption de croissance est plus élevée que la température à laquelle le matériau de points quantiques a été séparé.

3. Procédé selon la revendication 1 ou 2,
**caractérisé en ce que**,
concernant le composant à semi-conducteur, il s'agit d'un composant optoélectronique.

4. Procédé selon au moins une des revendications 1 à 3,
**caractérisé en ce que**
le composant à semi-conducteur contient un guide d'ondes.

5. Procédé selon au moins une des revendications 1 à 4,
**caractérisé en ce que**,
concernant le composant à semi-conducteur, il s'agit d'un laser.

6. Procédé selon au moins une des revendications 1 à 4,
**caractérisé en ce que**,
concernant le composant à semi-conducteur, il s'agit d'un amplificateur.

7. Procédé selon au moins une des revendications 1 à 4,
**caractérisé en ce que**,
concernant le composant à semi-conducteur, il s'agit d'un modulateur.

8. Procédé selon au moins une des revendications 1 à 4,
**caractérisé en ce que**,
concernant le composant à semi-conducteur, il s'agit d'un photodétecteur.

9. Procédé selon la revendication 1 ou 2,
**caractérisé en ce que**
le front de croissance est lissé pendant l'interruption de croissance.

10. Procédé selon au moins une des revendications 1 à 4 et 9,
**caractérisé en ce que**
les pertes de guide d'ondes sont réduites.

11. Procédé selon au moins une des revendications 1 à 10,
**caractérisé en ce que**,
en cas de pile multiple de couches de points quantiques, la déposition d'une couche de points quantiques suivante s'effectue immédiatement après l'interruption de croissance décrite dans la revendication 1.
